# EUROPEAN PATENT SPECIFICATION

(11) **EP 4 486 936 B1**
(45) Date of publication and mention of the grant of the patent: **17.12.2025**
(21) Application number: 23709482.6
(22) Date of filing: 27.02.2023
(51) Int. Cl.: C25B 1/04, C25B 11/031, C25B 11/052, C25B 11/061, C25B 11/093, C23C 14/18, C25D 3/48, C25D 3/50, C25D 7/06

(54) **DURABLE HYDROGEN EVOLUTION ELECTROCATALYST BASED ON 3D TIO2/CU MICRORODS DECORATED WITH NOBLE METAL NANOPARTICLES ON A CU SUBSTRATE**
DAUERHAFTER WASSERSTOFFENTWICKLUNGSELEKTROKATALYSATOR AUF BASIS VON 3D-TIO2/CU-MIKROSTÄBCHEN MIT EDELMETALLNANOPARTIKELN AUF EINEM CU-SUBSTRAT
ÉLECTROCATALYSEUR À DÉGAGEMENT D'HYDROGÈNE DURABLE À BASE DE MICROTIGES DE TIO2/CU 3D PARÉES DE NANOPARTICULES DE MÉTAL NOBLE SUR UN SUBSTRAT DE CU

(30) Priority: 28.02.2022 IT 202200003677
(43) Date of publication of application: 08.01.2025
(73) Proprietor: Fondazione Istituto Italiano di Tecnologia, 16163 Genova (IT)
(72) Inventor: ZUO, Yong, 16163 Genova (IT); SHINDE, Dipak Vijaykumar, 16163 Genova (IT); MANNA, Liberato, 16163 Genova (IT); DE TRIZIO, Luca, 16163 Genova (IT)
(74) Representative: Biggi, Cristina
(86) International application number: PCT/IB2023/051802
(87) International publication number: WO 2023/161892

(56) References cited:
- WO-A1-2020/255005
- SHINDE DIPAK V. ET AL: "A robust and highly active hydrogen evolution catalyst based on Ru nanocrystals supported on vertically oriented Cu nanoplates", JOURNAL OF MATERIALS CHEMISTRY A, vol. 8, no. 21, 1 January 2020 (2020-01-01), GB, pages 10787 - 10795, XP093009772, ISSN: 2050-7488, DOI: 10.1039/D0TA03475D
- DIPAK V. SHINDE ET AL: "In Situ Dynamic Nanostructuring of the Cu?Ti Catalyst-Support System Promotes Hydrogen Evolution under Alkaline Conditions", APPLIED MATERIALS & INTERFACES, vol. 10, no. 35, 8 August 2018 (2018-08-08), US, pages 29583 - 29592, XP055673874, ISSN: 1944-8244, DOI: 10.1021/acsami.8b09493
- GAO JING ET AL: "Hollow Nanotube Ru/Cu 2+1 O Supported on Copper Foam as a Bifunctional Catalyst for Overall Water Splitting", CHEMISTRY - A EUROPEAN JOURNAL, vol. 26, no. 18, 15 November 2019 (2019-11-15), DE, pages 4112 - 4119, XP093009894, ISSN: 0947-6539, DOI: 10.1002/chem.201904337

## Description

The project leading to this application has received funding from the European Union's Horizon 2020 research and innovation programme under grant agreement No. 899412 (HyCat).

### Technical field

The present invention relates to an electrocatalyst comprising a Cu substrate coated with a 3D TiO₂/Cu microrods array decorated with nanoparticles of a noble metal, preferably Ru nanoparticles, an electrochemical cell comprising said electrocatalyst and their use for hydrogen production *via* hydrogen evolution reaction (HER) in basic conditions. The present invention also refers to an *in-situ* process for producing said electrocatalyst and hydrogen and to a process for producing hydrogen, which comprises utilizing said electrochemical cell.

### Background art

Hydrogen is regarded as a next-generation fuel for the future "green economy". Unlike conventional fossil fuels, the by-product of hydrogen combustion is only water, which, in turn, can be recycled as a source for the hydrogen production. Nowadays, industries mainly rely on the so called "grey hydrogen", which is produced from methane steam reforming, a non-environmentally friendly process whose by-products are CO and CO₂. Besides, this process is energy-intensive and, thus, not economically sustainable. In this regard, the most promising alternative solution is the production of hydrogen *via* water splitting and by employing electricity originated from renewable energy sources (e.g., solar, wind, etc.).

However, the water splitting process requires efficient electrocatalysts which can drive the hydrogen evolution reaction (HER) at the cathode and the oxygen evolution reaction (OER) at the anode. Between these two processes, the OER is the rate limiting one and, to date, efficient catalysts to boost it have been found to work mostly under alkaline media (e.g., NiFe).

For this reason, the current research aim is to develop a highly active HER catalyst capable of working under alkaline conditions to achieve the industrial practical current density of -200 mA/cm² at an overpotential lower than 100 mV. In this regard, a suitable HER catalyst for industrial purposes should be stable under operational conditions and have a good trade-off between activity and cost. Although various HER electrocatalysts based on non-noble metal have been reported, currently the platinum group metals (PGM)-based catalysts are the most active ones.

To date, one of the most active and widespread catalysts in the sector is based on platinum deposited on mesoporous carbon (Pt/C). Although such a catalyst shows a high activity for HER, it suffers from several disadvantages, which include the following facts:
- its activity quickly degrades under operational conditions due to the agglomeration of Pt particles on the carbon support, resulting in a loss of active sites;
- it is not efficient in the production of hydrogen under high current conditions due to the so called "bubble build-up effect", which consists in the difficulty of the formed hydrogen bubbles to escape from the catalyst's surface;
- the Pt/C catalyst is in powder form, thus requiring to be immobilized on the current collector substrate with the help of binders. Usually, such binders are electrically insulating (e.g. Nafion), lowering the overall number of active sites and leading to an inefficient hydrogen evolution. Moreover, the hydrogen bubbles, vigorously evolving during the reaction, may cause the detachment of the catalyst from the substrate, which, in turn, results in a decrease of the final HER activity.

During the past few years, several efforts have been directed towards improving the stability of Pt-based catalysts and to minimize the loading of the active material (due to the high cost of Pt).

Some examples are given by the Pt_{SA}-NiO/Ni or Pt_{SA}-Co(OH)₂@Ag nanowires (SA: single atom) electrocatalysts described by K.L. Zhou et al. respectively in "Platinum single-atom catalyst coupled with transition metal/metal oxide heterostructure for accelerating alkaline hydrogen evolution reaction", Nat. Comm., 2021, 12, 3783, and in "Seamlessly conductive Co(OH)2 tailored atomically dispersed Pt electrocatalyst with a hierarchical nanostructure for an efficient hydrogen evolution reaction", Energy Environ. Sci., 2020, 13, 3082-3092.

However, the performances of these electrocatalysts are still not satisfactory as they require an overpotential of 85 mV and 104 mV, respectively, to achieve -100 mA/cm² of HER current in basic conditions.

J. Gao et al. in "Hollow nanotube Ru/Cu2+1O supported on copper foam as a bifunctional catalyst for overall water splitting", Chem. Eur. J., 2020, 26, 4112-4119, reported a Ru-doped Cu₂₊₁O nanotube arrays grown in situ on a Cu foam for the whole water splitting. Nevertheless, such electrocatalyst requires a high overpotential of around 120 mV to achieve only -80 mA/cm² in basic conditions.

In a previous patent application of the Applicant itself, WO2020/255005, it was disclosed a strategy to immobilize noble metal nanoparticles, in particular Pt nanoparticles, on Cu nanoplatelets vertically grown on a Ti substrate, to obtain a porous Cu-Pt/Ti HER catalyst.

In a later work, the Applicant, in the work *"*A robust and highly active hydrogen evolution catalyst based on Tu nanocrystals supported on vertically oriented Cu nanoplates", J. Mater. Chem. A, 2020, 8, 10787*",* described an analogous porous HER catalysts made of Ru nanoparticles immobilized on the same Cu nanoplatelets vertically grown on a Ti substrate (Cu-Ru/Ti).

Although such Cu-Ru/Ti electrocatalyst showed improved performance compared to the commercial Pt/C and the Cu-Pt/Ti electrocatalyst, the activity was still not satisfactory as it required an overpotential of around 140 mV to drive a current density of -200 mA/cm². Hence, it appears clear that the above-mentioned materials are still far from an ideal electrocatalyst for HER in alkaline conditions.

Therefore, in the field of HER there is a strong need to produce a noble metal-based catalyst, which is easy to prepare, stable on long term and featuring improved performance in basic media.

The present invention solves the prior art issues by providing an electrocatalyst comprising a Cu substrate, preferably at least a Cu mesh or a Cu foil, or a plurality of Cu meshes or Cu foils forming a stack, onto which a 3D TiO₂/Cu microrods array is grown and subsequently decorated with nanoparticles of a noble metal, preferably Ru nanoparticles, with an improved hydrogen evolution activity and long-term stability in basic media and an *in-situ* process for simultaneously producing said electrocatalyst and hydrogen. The present invention also solves the prior art criticalities by providing an electrochemical cell comprising said electrocatalyst and a process for producing hydrogen which comprises utilizing said electrochemical cell.

### Summary of the invention

The present invention relates to an electrocatalyst comprising a Cu substrate selected from a Cu mesh, a Cu foil or a plurality of Cu meshes or Cu foils forming a stack, onto which a 3D TiO₂/Cu microrods array is grown and subsequently decorated with nanoparticles of a noble metal. According to the present invention, said 3D TiO₂/Cu microrods array comprises TiO₂/Cu microrods vertically oriented with respect to said Cu substrate. Preferably said noble metal is selected from the group consisting of: platinum (Pt), palladium (Pd), ruthenium (Ru) and gold (Au). More preferably said noble metal is ruthenium (Ru).

The present invention also relates to an *in-situ* process for the preparation of said electrocatalyst which also allows the simultaneous production of hydrogen.

Another object of the present invention is an electrochemical cell and a process for producing hydrogen which comprises utilizing said electrochemical cell. According to the present invention, the electrochemical cell has a 3-electrode configuration comprising the electrocatalyst of the invention as the working electrode, a counter electrode, a reference electrode and an aqueous basic electrolyte solution, optionally comprising a precursor of a noble metal, preferably a Ru precursor.

The present invention also refers to the use of said electrocatalyst and said electrochemical cell for hydrogen production *via* hydrogen evolution reaction (HER) under basic conditions.

### Brief description of the drawings

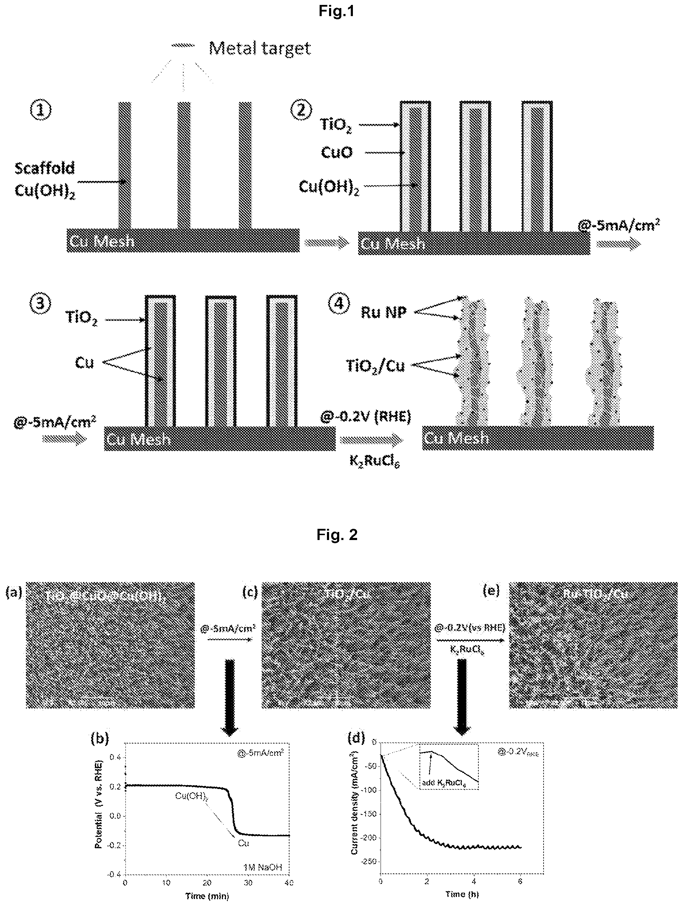

Figure 1 shows a scheme of the *in-situ* fabrication procedure of the electrocatalyst comprising TiO₂/Cu microrods decorated with Ru nanoparticles on a Cu mesh (also called, for the purposes of the present invention Ru-TiO₂/Cu electrocatalyst) as described in Example 1.
Figure 2 shows: (a) SEM (Scanning Electron Microscope) image of the produced Cu(OH)₂ microrods on the Cu substrate after sputtering the Cu and Ti layers (also called, for the purposes of the present invention Ti@Cu@Cu(OH)₂ microrods, which after oxidation of the Cu and Ti layers in air become TiO₂@CuO@Cu(OH)₂ microrods) as described in Example 1; (b) chronopotentiometry (CP) plot recorded on an Ivium-n-Stat potentiostat showing electroreduction of Cu(OH)₂ to Cu⁰ at -5 mA/cm² as described in Example 1; (c) SEM image of TiO₂/Cu microrods on the Cu substrate of Example 1; (d) the evolution of current density as a function of chronoamperometry (CA) time at an applied potential of -0.2 V vs. RHE; and (e) SEM image of the electrocatalyst of the invention comprising Ru-TiO₂/Cu microrods on a Cu mesh substrate as obtained in Example 1.

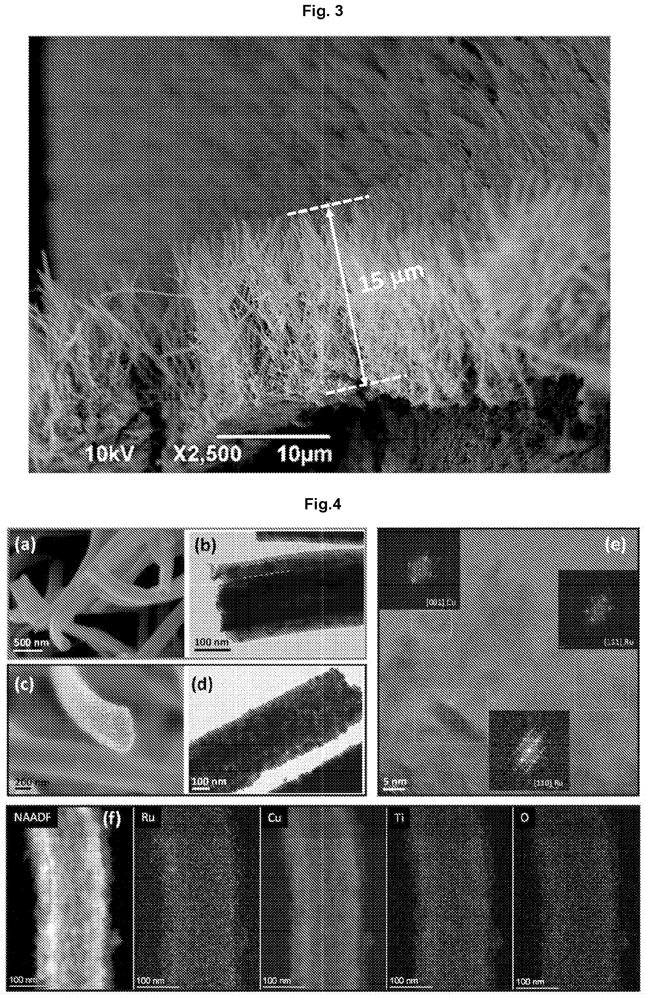

Figure 3 is a SEM image showing the length of the Ru-TiO₂/Cu microrods as obtained in Example 1.
Figure 4 shows the characterization of Ti@Cu@Cu(OH)₂ microrods and of the final Ru-TiO₂/Cu microrods based on the former: (a) High-resolution SEM (HRSEM) and (b) TEM (Transmission Electron Microscope) image of the Cu(OH)₂ microrods after sputtering the Cu and Ti layers and subsequent oxidation grown on the Cu substrate. The dash lines indicate the border of the layer; (c) SEM, (d) TEM image, (e) High-resolution TEM (HRTEM) image and (f) EDS mapping of Ru-TiO₂/Cu microrods.

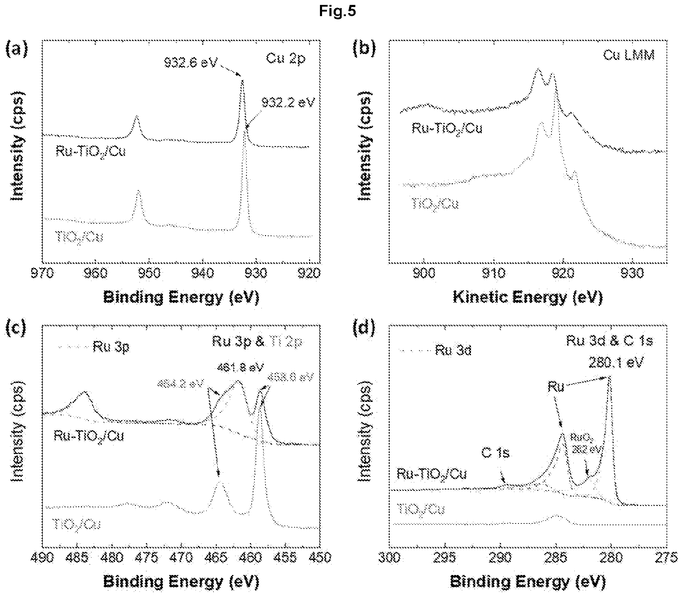

Figure 5 shows the XPS analysis of the Ru-TiO₂/Cu electrode as obtained in Example 1 compared with those of the TiO₂/Cu electrode (i.e. not decorated with Ru nanoparticles), acquired over the energy ranges typical for: (a) Cu 2p; (b) Cu LMM; (c) Ru 3p (overlapping with Ti 2p); and (d) Ru 3d (overlapping with C 1s).

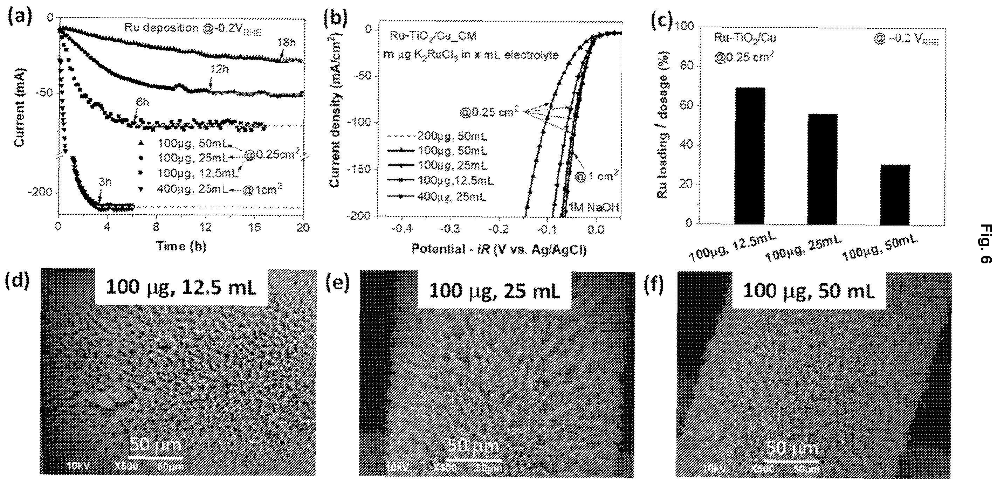

Figure 6 shows: (a) the evolution of current as a function of CA time at an applied potential of -0.2 V vs. RHE; (b) LSV plots of produced Ru-TiO₂/Cu electrode by adding same Ru precursor dosage into various electrolyte volumes; (c) SEM images of produced 0.25 cm² Ru-TiO₂/Cu by adding 100 µg Ru precursor into (d) 12.5 mL, (e) 25 mL and (f) 50 mL electrolyte of 1M NaOH, as described in Example 3.

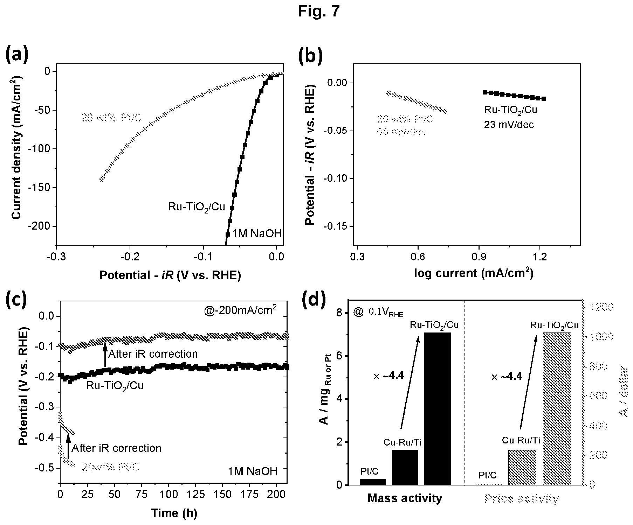

Figure 7 shows electrochemical measurements of Ru-TiO₂/Cu microrods and, as comparison, commercial 20 wt.% Pt/C, deposited on a Cu mesh substrate as described in Example 4: (a) LSV plots (iR corrected); (b) Tafel plots derived from the corresponding LSV data; (c) stability test recorded at -200 mA/cm² (no iR corrected, and iR corrected); (d) mass activity (current per unit mass) and price activity (current per unit price), wherein the results with the previous Cu-Ru/Ti electrocatalyst, described in J. Mater. Chem. A, 2020, 8, 10787, are also present as a comparison.

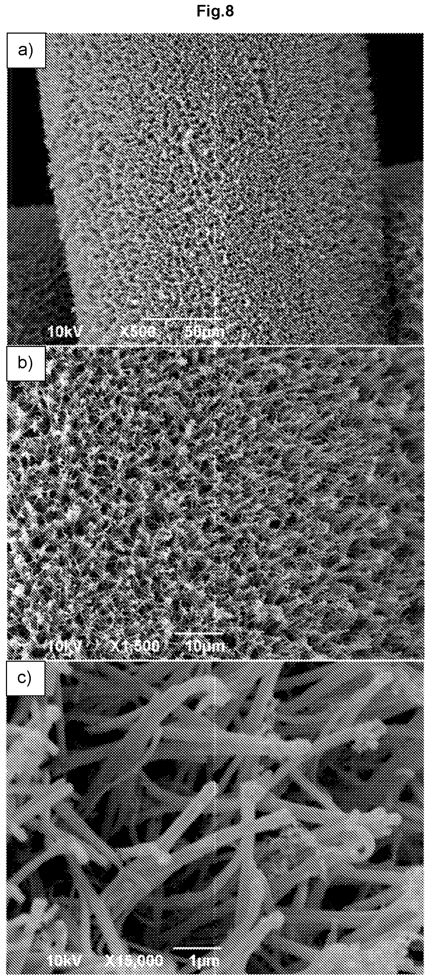

Figure 8 shows SEM images at different magnifications ((a), (b) and (c)) of the Ru-TiO₂/Cu electrocatalyst according to the present invention after continuous hydrogen evolution for 200 hours at a current density of -200 mA/cm².

### Detailed description of the preferred embodiments of the invention

For the purposes of the present invention, "nanoparticle of a noble metal" or "noble metal nanoparticle" refers to a nanoparticle of a noble metal, i.e. a metal selected from ruthenium (Ru), rhodium (Rh), palladium (Pd), silver (Ag), osmium (Os), iridium (Ir), platinum (Pt), and gold (Au), in the "0" oxidation state (M⁰). For example, "Ru nanoparticle" refers to a nanoparticle of metallic Ru, which means that Ru is present exclusively in the "0" oxidation state (Ru⁰).

For the purposes of the present invention, "amorphous TiO₂" and "amorphous TiO₂ nanoparticle" refer to amorphous titanium dioxide (titanium (IV) oxide).

For the purposes of the present invention, the terms "electrocatalyst" and "electrode" are used as equivalent and interchangeable synonyms. An electrocatalyst is a catalyst that participates in an electrochemical reaction (i.e. functioning at electrode surfaces or being the electrode surface itself) by modifying and increasing the rate of the reaction without being consumed in the process.

For the purposes of the present invention, the term "nanoparticle" can be also intended as a synonym of "nanocrystal".

For the purposes of the present invention, the terms "basic condition(s)" and "alkaline condition(s)" are used as equivalent and interchangeable synonyms.

For the purposes of the present invention, the expression "plurality of Cu meshes forming a stack" refers to a Cu substrate formed by stacking one upon another two or more Cu meshes. The resulting stacked structure has properties similar to those of a Cu foam with regards to the (high) porosity.

For the purposes of the present invention, the term "microrod(s)" is used as a synonym of "microwire(s)" which, in the present case are objects having a diameter of hundreds of nanometers, preferably between 200 and 500 nm and a length of micrometers, preferably between 10 and 20 µm, more preferably a mean length of about 15 µm.

For the purposes of the present invention, the expression "TiO₂/Cu microrod" refers to a microrod made of TiO₂ and Cu⁰, wherein TiO₂ is preferably present in the form of amorphous TiO₂ nanoparticles.

For the purposes of the present invention, "mean diameter" and "mean length" means the "average diameter" and "the average length". "Average" is the arithtnetic mean of the sum of all the values divided by the total number of values in a given set.

For the purposes of the present invention "area" of the substrate mesh/foil means the projected area of the substrate mesh/foil.

The present invention relates to an electrocatalyst comprising a Cu substrate onto which a 3D TiO₂/Cu microrods array is grown and subsequently decorated with nanoparticles of a noble metal.

In other words, the present invention relates to an electrocatalyst comprising a Cu substrate coated with a 3D TiO₂/Cu microrods array decorated with nanoparticles of a noble metal.

According to the present invention, said Cu substrate is a Cu mesh, a Cu foil, or a plurality of Cu meshes or Cu foils forming a stack.

According to the present invention, said 3D TiO₂/Cu microrods array comprises TiO₂/Cu microrods vertically oriented with respect to said Cu substrate. In other words, for the purposes of the present invention, it can be said that said 3D TiO₂/Cu microrods array comprises hierarchically organized arrays of TiO₂/Cu microrods vertically grown onto said Cu substrate forming a three-dimensionally matrix.

Such a three-dimensionally matrix has a large surface area that is electrochemically active, because the microrods expose a wide external area. In addition, the hierarchically organized network of the microrods define a non-compact structure with infoldings and porosity. Therefore, such 3D TiO₂/Cu microrods array can be intended, for the purposes of the present invention, as a porous matrix.

In addition, as described below and in the experimental section, also the microrods themselves are porous microrods.

Preferably, said 3D TiO₂/Cu microrods have a mean length between 10 and 20 µm, more preferably a mean length of about 15 µm, measured by SEM technique.

Preferably, said 3D TiO₂/Cu microrods have a mean diameter between 200 and 500 nm, more preferably a mean diameter of about 250 nm, measured by SEM technique.

According to an embodiment of the present invention, the TiO₂, which forms the 3D TiO₂/Cu microrods, is present, within the overall electrocatalyst of the invention, is in an amount between 10 and 40 µg/cm², more preferably between 20 and 35 µg/cm². Without wishing to be bound to a specific theory, the Applicant has found that the HER performance of the electrocatalyst according to the present invention is strongly influenced by the specific amount of TiO₂. As already described in ACS Appl. Mater. Interfaces 2018, 10, 29583-29592, the Applicant, has previously found that the role of TiOₓ is to facilitate the water dissociation step, therefore improving the HER catalytic activity in alkaline conditions. Nevertheless, considering that TiOₓ is not a conductive material, its relative amount in the final electrode has to be rationally tuned as in the case of the present invention in order to boost the overall catalytic activity while keeping a good electron transfer.

According to an embodiment of the present invention, said nanoparticles of a noble metal decorating the 3D TiO₂/Cu are present, within the overall electrocatalyst of the invention, in an amount between 30 and 60 µg/cm², preferably between 40 and 55 µg/cm².

According to one embodiment of the invention, the nanoparticles of a noble metal have a mean diameter measured by HRTEM (High-Resolution Transmission Electron Microscopy) technique of between 0.5 and 4 nm, preferably between 1 and 3 nm. Said nanoparticles of a noble metal can be also defined, for the purpose of the present invention, as "ultra-small" nanoparticles.

Preferably said noble metal is selected from the group consisting of: platinum (Pt), palladium (Pd), ruthenium (Ru) and gold (Au). More preferably said noble metal is ruthenium (Ru). Advantageously, the presence of nanoparticles of a noble metal decorating the 3D TiO₂/Cu microrods array on a Cu substrate of the electrocatalyst according to the present invention, allows to have a high hydrogen evolution efficiency.

For the purposes of the present invention, the 3D TiO₂/Cu microrods decorated with noble metal nanoparticles can be intended as highly porous microrods composed of Cu and amorphous TiO₂ nanoparticles homogeneously distributed along the whole microrod itself which is in turn homogeneously decorated with noble metal nanoparticles.

Without wishing to be bound to any specific theory, the high catalytic activity of the electrocatalyst of the present invention can be attributed to the following factors and their synergistic combination:
- the high catalytic activity of noble metal nanoparticles towards the hydrogen evolution reaction (HER);
- the rationally and specifically designed composition of the TiO₂/Cu microrods, wherein the presence of TiO₂ helps in dissociating water by binding OH species and releasing H species, while the noble metal nanoparticles decorating the surface of the microrods lead to the production of H₂ by combining H species, and the presence of Cu of the microrod together with the Cu substrate provides good electrical conductivity, thus guaranteeing an effective charge transfer and minimizing the charge transfer resistance;
- the porosity of the TiO₂/Cu microrods as well as of the overall electrocatalyst as defined above allows for a very large surface area and thus a large electrochemically active surface area (ECSA), which facilitates the in-diffusion of the electrolyte ions and the out-diffusion of the formed hydrogen gas (H_{2(g)});
- the intimate contact and strong binding between the noble metal nanoparticles and the TiO₂/Cu microrods and the dynamic structure of the microrods array itself prevent the agglomeration of the noble metal nanoparticles;
- the strong link between the TiO₂/Cu microrods and the Cu substrate avoids the detachment of the TiO₂/Cu microrods from the Cu substrate during the HER process even with no use of binders.

Thanks to the combination of these factors, the electrocatalyst of the present invention can sustain high current densities at high applied potentials with an excellent stability under HER operational conditions.

Preferably the electrocatalyst of the invention does not undergo degradation in such conditions and it can be used several times without the need to be regenerated.

In particular, the electrocatalyst of the invention advantageously maintains its original activity for over 200 hours of continuous operation at -200 mA/cm² (namely, industrial-level current density) at an overpotential comprised between 60 and 100 mV, preferably between 60 and 75 mV, in basic conditions. Preferably, the electrocatalyst of the invention advantageously maintains 100% of its original activity after 210 hours of continuous operation, at a 70 mV overpotential and -200 mA/cm² current density.

Another object of the present invention is an *in-situ* process for the preparation of the above-described electrocatalyst and simultaneous production of hydrogen. Said *in-situ* process comprises the steps of:
(a) providing a Cu substrate onto which vertically oriented Cu(OH)₂ microrods are grown;
(b) coating the Cu(OH)₂ microrods surface by means of a sputtering technique, preferably by means of a sputter coater, with a Cu layer, and, subsequently, with a Ti layer;
(c) providing an electrochemical cell having a 3-electrode configuration comprising a starting working electrode which comprises the Cu substrate coated with the vertically oriented Cu(OH)₂ microrods as obtained after step (b), the cell further comprising a counter electrode and a reference electrode;
(d) adding an aqueous basic electrolyte solution to the cell of step (c) and applying a negative current density to the cell, to obtain TiO₂/Cu microrods;
(e) adding a solution comprising a precursor of a noble metal directly into the aqueous basic electrolyte solution of step (d) and applying a negative potential with respect to the reference electrode to the cell.

According to one embodiment of the invention, the Cu(OH)₂ microrods of step (a) are deposited on the Cu substrate by a deposition process comprising the steps of:
(a.I) providing an aqueous basic solution, preferably an aqueous basic solution having a pH > 14, more preferably an aqueous basic solution comprising ammonium persulfate and sodium hydroxide;
(a.II) immersing a pre-cleaned Cu substrate into said solution at room temperature, said Cu substrate being used as Cu precursor for the heterogeneous nucleation reaction of vertically oriented Cu(OH)₂ microrods on the substrate.

According to an embodiment of the invention, said aqueous basic solution of step (a.I) comprises 0.1 M ammonium persulfate and 2 M sodium hydroxide.

According to an alternative embodiment, said ammonium persulfate can be substituted with sodium persulfate or other similar oxidants.

The aqueous basic electrolyte solution of step (d) is preferably in a concentration of between 0.1 M and 1 M. Preferably said aqueous basic electrolyte solution is selected from the group consisting of NaOH, KOH and LiOH aqueous solutions and combination thereof. More preferably the aqueous basic electrolyte solution is a NaOH aqueous solution. Even more preferably, the aqueous basic electrolyte solution is a 1 M NaOH aqueous solution. Preferably the precursor of a noble metal of step (e) is in a concentration of between 0.2 and 10 µg/ml, preferably between 0.4 and 8 µg/ml. Preferably said noble metal is selected from the group consisting of: platinum (Pt), palladium (Pd), ruthenium (Ru) and gold (Au). More preferably said noble metal is ruthenium (Ru). Preferably said precursor of a noble metal is selected from the group consisting of complex salts of said noble metal which are soluble in the aqueous basic electrolyte solution of step (e). In a particularly preferred embodiment of the present invention, said precursor of a noble metal is a Ru precursor, preferably selected from a complex salt of ruthenium, more preferably selected from K₂RuCl₆, (NH₄)₂RuCl₆ and combination thereof. In another embodiment of the present invention, said precursor of a noble metal is a Pt precursor, preferably selected from a complex salt of platinum, more preferably selected from K₂PtCl₆, Na₂PtCl₆, H₂PtCl₆, (NH₄)₂PtCl₆ and combination thereof. Even more preferably, the Pt precursor is Na₂PtCl₆.

In another embodiment of the present invention, said precursor of a noble metal is a Pd precursor, preferably selected from a complex salt of palladium, more preferably selected from (NH₄)₂PdCl₆, Na₂PdCl₆, K₂PdCl₆ and combination thereof. In another embodiment of the present invention, said precursor of a noble metal is an Au precursor, preferably selected from a complex salt of gold, more preferably selected from NaAuCl₄·2H₂O, KAuCl₄·2H₂O, NH₄AuCl₄·H₂O and combination thereof.

Preferably the reference electrode is selected from the group consisting of: aqueous reference electrodes, such as saturated calomel electrode, silver/silver chloride electrode, silver/silver sulfate electrode, mercury/mercurous sulfate electrode and mercury/mercury oxide electrodes. Preferably, the reference electrode is an aqueous reference electrode, more preferably a double-junction Ag/AgCl (3.8 M KCI) reference electrode.

According to a preferred embodiment of the invention, the reference electrode in the cell of step (c), is a double junction Ag/AgCl (3.8 M KCI) and, preferably, the negative current density applied in step (d) is comprised between -1 and -10 mA/cm², more preferably of around -5 mA/cm², and the negative potential applied in step (e) is preferably between -1.1 and -1.3 V, more preferably of between -1.2 and -1.25 V against the Ag/AgCl (3.8 M KCI) reference electrode.

However, it is clear that a skilled man in the art would be able to use any type of reference electrode suitable and available for this type of process and adapt the potential to be applied accordingly.

The counter electrode is selected from electrically conducting materials such as nickel, titanium, gold, graphite rod and platinum, preferably a Pt wire. Preferably, said negative potential applied in step (c) is a constant potential.

Advantageously, such an *in-situ* process leads to the production of an electrode comprising a Cu substrate coated with a 3D TiO₂/Cu microrods array decorated with noble metal nanoparticles (i.e. the electrocatalyst according to the present invention as described above) and the simultaneous production of hydrogen.

Without wishing to be bound to any specific theory, the *in-situ* process according to the present invention results in the desired electrocatalyst according to the present invention and hydrogen, thanks to the following electrochemical process:
- the Cu and Ti layers formed in step (b) are at least partially oxidized when exposed to air forming layers of CuO and amorphous TiO₂ at the surface of the microrods. For the purposes of the present invention, the microrods obtained after step (b) can be defined as Ti@Cu@Cu(OH)₂, or better, TiO₂@CuO@Cu(OH)₂ microrods, which are composed of relatively smooth Ti, Cu and Cu(OH)₂ sandwiched layers (with the Cu and Ti layers being oxidized into TiO₂ and CuO layers);
- subsequently, in step (d) thanks to the negative current density applied as described above, the Cu(OH)₂ and the CuO formed after step (b), are reduced to metallic Cu, resulting in the formation of highly porous TiO₂/Cu microrods. It should be noted that, advantageously, in these conditions the TiO₂ formed after step (b) cannot be reduced back to Ti⁰;
- finally, in step (e) the applied potential leads to the reduction of the noble metal ions present in the aqueous electrolyte basic solution of step (d) in their oxidized state (Mⁿ⁺) to M⁰, which deposits on the surface of the porous TiO₂/Cu microrods array and nucleates on it, thus forming noble metal nanoparticles; for example in the case of a particularly preferred embodiment of the invention, said part of the applied potential of step (e) leads to the reduction of the Ru⁴⁺ ions present in the aqueous electrolyte basic solution of step (d) to Ru⁰, which deposit on the surface of the porous TiO₂/Cu microrods and nucleates on it, thus forming Ru nanoparticles;
- the remaining part of the applied potential is consumed by the hydrogen evolution reaction.

Preferably, the amount of the electrodeposited noble metal nanoparticles decorating the TiO₂/Cu microrods increases during the first period of application of the negative potential, preferably after 3 hours from the start of the application, and then it remains constant. Such deposition procedure has been substantially and advantageously shortened if compared to what reported by the applicant in the previous work, J. Mater. Chem. A, 2020, 8, 10787*,* where the Ru deposition is achieved after 15 hours. Preferably, the electrodeposited noble metal nanoparticles are in the amounts described above.

Advantageously, the final noble metal content can be adjusted by varying the amount of precursor of the noble metal present in the electrolyte solution of step (d).

The here described electrocatalyst and the relating *in-situ* process for its production and simultaneous hydrogen evolution, find application in the field of alkaline electrolyzers with many advantages. In particular, the direct *in-situ* formation of the electrocatalyst is easily feasible and avoids the use of expensive and tedious *ex-situ* techniques, thus reducing the cost of the catalyst itself.

Without wishing to be bound to any specific theory, it can be envisaged that such an *in-situ* process leads to the production of the electrocatalyst of the invention with all the above-described features and to the simultaneous hydrogen production. In particular, the process advantageously minimizes the deposition time of the noble metal nanoparticles to less than 5 hours, preferably to only 3 hours. Furthermore, being the electrodeposited noble metal nanoparticles solidly anchored to the TiO₂/Cu microrods, no aggregation of said noble metal nanoparticles occurs even after prolonged use. This phenomenon results in the overall stability of the electrocatalyst even after a vigorous hydrogen evolution achieved under high current conditions, which are typically employed in commercial alkaline electrolyzers. As already mentioned above, the porous nature of the TiO₂/Cu microrods as well as of the overall electrocatalyst maximizes the number of active sites accessible for the hydrogen evolution reaction and, at the same time, allows the formed hydrogen bubbles to easily escape, therefore allowing the electrocatalyst of the present invention to sustain, during the described in situ process, high current densities at high applied potentials with an excellent stability under HER operational conditions for over 200 hours of continuous operation at -200 mA/cm² (namely, industrial-level current density) at an overpotential comprised between 60 and 100 mV, preferably between 60 and 75 mV in basic conditions.

Preferably the *in-situ* process for the production of the electrocatalyst of the invention and hydrogen, allows to obtain a stable electrocatalyst which does not undergo degradation in such conditions and can be used in the hydrogen evolution reaction several times without the need to be regenerated.

Another object of the present invention concerns an electrochemical cell having a 3-electrode configuration comprising the above-described electrocatalyst according to the present invention as the working electrode, a counter electrode, a reference electrode and an aqueous basic electrolyte solution.

Such an electrochemical cell can therefore be obtained by inserting the electrocatalyst of the present invention in a 3-electrode configuration cell further comprising a counter electrode and a reference electrode and adding an aqueous basic electrolyte solution to said cell.

According to one embodiment of the invention, said electrochemical cell comprises an aqueous basic electrolyte solution further comprising a precursor of a noble metal as described above.

Preferably, the reference electrode is selected from the group consisting of: aqueous reference electrodes, such as saturated calomel electrode, silver/silver chloride electrode, silver/silver sulfate electrode, mercury/mercurous sulfate electrode and mercury/mercury oxide electrodes. Preferably the reference electrode is an aqueous reference electrode, more preferably a double-junction Ag/AgCl (3.8 M KCI) reference electrode. The counter electrode is preferably selected from electrically conducting materials such as nickel, titanium, gold, graphite rod and platinum, preferably a Pt wire. Preferably, said aqueous basic electrolyte solution and the optional precursor of a noble metal are as described above.

The present invention also relates to a process for producing hydrogen comprising providing an electrochemical cell; and applying a negative potential with respect to the reference electrode to the cell.

According to a preferred embodiment of the invention, the reference electrode is a double junction Ag/AgCl (3.8 M KCI) and said negative potential applied is of between -1.1 and -1.3 V, preferably of between -1.2 and -1.25 V against the Ag/AgCl (3.8 M KCl) reference electrode.

Preferably, said negative potential applied is a constant potential.

Since said electrochemical cell comprises the electrocatalyst according to the present invention, during said process for producing hydrogen, said electrocatalyst is able to sustain high current densities at high applied potentials with an excellent stability under HER operational conditions, in particular for over 200 hours of continuous operation at -200 mA/cm² (namely, industrial-level current density) in basic conditions at an overpotential comprised between 60 and 100 mV, preferably between 60 and 75 mV in basic conditions. Preferably, during said process for the production of hydrogen, the electrocatalyst comprised in the electrochemical cell of the invention does not undergo degradation in the operative HER conditions and can be used in the hydrogen evolution reaction several times without the need to be regenerated.

Finally, the present invention relates to the use of the electrocatalyst as described above for hydrogen production *via* hydrogen evolution reaction under basic condition. The present invention also relates to the use of the above-described electrochemical cell comprising the electrocatalyst of the invention, for hydrogen production *via* hydrogen evolution reaction under basic condition.

### Examples

### Example 0 - Structural characterization and Elemental Analyses

### SEM - Scanning Electron Microscopy

SEM analyses were performed on electrodes at 10 KV on the JEOL JSM-6490LA instrument.

### HRTEM - High-resolution transmission electron microscopy

HRTEM micrographs were acquired using a JEOL JEM-2200FS, operating at 200 KV. The samples were prepared by scratching off the materials from the electrodes (i.e. the electrocatalysts) and dispersing them in ethanol. The catalyst dispersions were dropped onto 400 mesh ultrathin carbon coated Ni grids for imaging. The microscope was equipped with a Ω-type in-column image filter and a CEOS spherical aberration corrector for the objective lens. This enabled a spatial resolution of 0.9 Å.

### XPS - X-ray photoelectron spectroscopy

XPS analyses were performed on a Kratos Axis Ultra DLD spectrometer, using a monochromatic Al Kα source, operated at 20 mA and 15 kV. Low-resolution survey scans were acquired at an analyzer pass energy of 160 eV, whereas high-resolution scans were acquired in 0.1 eV steps at a constant pass energy of 20 eV, over the energy regions typical of the main XPS peaks for Cu, Ru and Ti. A takeoff angle (Φ) of 0° with respect to the surface normal was used to detect photoelectrons. The pressure in the analysis chamber was always kept below 6 x 10⁻⁹ Torr during the analysis. The data were processed using Casa XPS version 2.3.17. The C 1s peak at 284.8 eV was used as an internal reference for binding energy scale.

### ICP-OES - Inductively coupled plasma optical emission spectroscopy

The samples for ICP-OES analysis were prepared by cutting 0.25 cm² electrode and dissolving it in aqua regia overnight. The solutions were then diluted to 25 ml using deionized water. The analysis was performed on an iCAP 6300 DUO ICP-OES spectrometer (ThermoScientific).

### EDS - Energy dispersive X-ray spectroscopy

EDS was measured on a JEOL JEM-2200FS microscope, operating at 200 KV.

### Electrochemical measurements

The setup for electrochemical measurements consisted of an electrochemical cell containing Pt wire (counter electrode), the TiO₂/Cu microrods grown on a Cu mesh substrate of 0.25 cm² and/or 1 cm² area (working electrode), and a double-junction Ag/AgCl (3.8 M KCI) (reference electrode). All measurements were performed on an IVIUM Compactstat potentiostat. Linear sweep voltammograms (LSVs) were measured by scanning the potential between -0.9 and -1.3 V vs Ag/AgCl (3.8 M KCI) electrode. The chronoamperometry (CA) measurements were performed by applying various constant applied potentials. Impedance analysis was performed at a constant potential of -0.2 V vs RHE (Reversible Hydrogen Electrode). The spectra were recorded with a potential amplitude of 5 mV in a frequency range of 0.1 MHz to 0.1 Hz. All the potentials are reported versus the reversible hydrogen electrode scale (RHE), unless otherwise noted.

The potentials were converted using the following formula E_{RHE} = E_{obs} + E_{Ag/AgCl} + (0.0591 x pH), where E_{Ag/AgCl} has a value of 0.199 vs SHE (Standard Hydrogen Electrode) and E_{obs} refers to the actual observed potential.

### Example 1 - in-situ preparation of the electrocatalyst according to the present invention

A Ru-TiO₂/Cu electrocatalyst (namely an electrocatalyst comprising arrays of TiO₂/Cu microrods decorated with Ru nanoparticles) is produced according to the process of the present invention as shown in Figure 1. Firstly, Cu(OH)₂ microrods were produced on the surface of a Cu mesh (i.e. the Cu substrate) by immersing a piece of clean Cu mesh (1.5 x 3 cm²) into a water solution containing a mixture of 0.1 M ammonium persulfate and 2 M sodium hydroxide for 30 minutes at room temperature. The obtained electrode was then put in a sputter coater (Q150T ES PLUS) to first deposit a Cu layer (FTM: 60 nm, tooling factor: 3.4), and a Ti layer after (FTM: 30 nm, tooling factor: 3.4), onto the Cu(OH)₂ microrods surface. The resulting electrode, called Ti@Cu@Cu(OH)₂, was partially oxidized when exposed to air, forming layers of CuO and TiO₂ at the surface. The obtained Cu(OH)₂ microrods covered with oxidized Cu and Ti layers are vertically arranged on the surface of the Cu substrate, as shown in the scanning electron microscope (SEM) image in Figure 2(a). The electrode, cut from the Ti@Cu@Cu(OH)₂ electrode and having a working area of 1 cm², was then immersed in a 1M NaOH solution (i.e. electrolyte solution, 25 mL) and a current of -5 mA/cm² was applied on a three-electrode configuration, using Ag/AgCl (3.8M KCI) as the reference electrode and Pt wire as the counter electrode, to slowly reduce the Cu(OH)₂ core and the oxidized Cu layer (i.e. CuO layer) to metallic Cu, as shown in Figure 2(b) where the chronopotentiometry (CP plot) recorded on the Ivium-n-Stat potentiostat eventually becomes stable. This resulted in the formation of TiO₂/Cu microrods on the Cu substrate, as shown in Figure 2(c). The final step was the electrodeposition of Ru nanoparticles (Ru NPs) onto the surface of the TiO₂/Cu microrods (Figure 2(e)). This was achieved by adding K₂RuCl₆ (400 µg) to the electrolyte and by applying a potential of -0.2V (vs. RHE). As shown in Figure 2(d), the chronoamperometric (CA) current recorded on Ivium-n-Stat potentiostat increases upon the Ru precursor addition, indicating the initialization of the Ru deposition (and the simultaneous evolution of hydrogen).

The Ru-TiO₂/Cu microrods obtained have a length of around 15 µm as shown in the SEM image reported in Figure 3.

### Example 2 - characterization analysis

The electrocatalyst obtained in Example 1 was then characterized by means of Electron Microscopy (SEM, TEM, HRSEM, HRTEM), High-Angle Annular Dark-Field (HAADF), Energy-Dispersive X-ray Spectroscopy (EDS), X-ray Photoelectron Spectroscopy (XPS), and inductively coupled plasma optical emission spectroscopy (ICP-OES) analysis.

Figure 4(a) and (c) show a high-resolution SEM image of the Ti@Cu@Cu(OH)₂ and Ru-TiO₂/Cu samples carried out at 10 kV on the JEOL JSM-6490LA instrument. The initially smooth surface of the Cu-Ti microrods became rougher after the Ru nanoparticles deposition. By transmission electron microscope (TEM) imaging acquired at 120 KV on the JEOL JEM-2200FS TEM/STEM instrument, it is possible to appreciate that the Ti@Cu@Cu(OH)₂ microrods, which are composed of relatively smooth Ti, Cu and Cu(OH)₂ sandwiched layers (with the Cu and Ti layers being oxidized), at the end of the process are transformed into highly porous microrods covered by Ru nanoparticles (Figure 4(c) and (d)).

To gain more insights into the structure of these rods, high-resolution (HR) TEM images were aquired at 200 KV. As shown in Figure 4(e), a microrod is composed of small Cu and Ru nanoparticles. No TiO₂ crystallites could be detected via HRTEM, because TiO₂ is present in an amorphous state, considering the presented Ti species to be Ti (IV) according to the following XPS result. The Energy-Dispersive X-ray Spectroscopy mapping (Figure 4(f)) reveals the homogeneous distribution of Ru, Cu, Ti, O elements along the whole microrod.

To determine the surface oxidation state and chemical environment of Cu, Ti, and Ru species before and after the Ru nanoparticles deposition, X-ray photoelectron spectroscopy (XPS) analysis was performed on a Kratos Axis Ultra DLD spectrometer, using a monochromatic Al Kα source, operated at 20 mA and 15 kV. The Cu 2p signals (Figure 5(a)) of the starting electrode (TiO₂/Cu) (namely, the electrode of the invention as obtained in Example 1 before the electrodeposition of the Ru nanoparticles) indicate that Cu is mainly present in the 0 oxidation state, while the Cu LMM spectrum (Figure 5(b)) indicates a minor presence of Cu(I) species along with Cu(0). The presence of such Cu(I) species was ascribed to oxidation (operated by air) of the electrode after its removal from the HER operational conditions for analysis purposes. Notably, after the deposition of Ru, the Cu 2p and Cu LMM peaks shifted to higher binding energies, indicating the occurrence of an electron transfer from Cu to Ru. In this regard, it has been previously reported that negatively charged Ru is beneficial for promoting the HER (Q.L. Wu, et al., Identifying Electrocatalytic Sites of the Nanoporous Copper-Ruthenium Alloy for Hydrogen Evolution Reaction in Alkaline Electrolyte, ACS Energy Lett., 2020, 5, 192-199). The Ti 2p peak (Figure 5(c)) reveals that Ti is in the +4 oxidation state, which was ascribed to the oxidation under the air of sputtered Ti layer, which cannot be reduced back to Ti (0) under HER conditions.

Interestingly, the Ti 2p signals become broader after the Ru deposition. The 3p peak of Ru (Figure 5(d)) is compatible with an oxidation state of 0, while the Ru 3d signal (Figure 5(d)) indicated the presence of a small amount of RuO₂. Inductively coupled plasma optical emission spectroscopy (ICP-OES) analysis revealed that the Ru amount in the Ru-TiO₂/Cu electrode was 52 µg/cm², while the Ti amount was 31 µg/cm².

### Example 3 - optimization of the deposition time of Ru nanoparticles

The Ru nanoparticles deposition time (to reach stabilization on the CP plot) was investigated (Figure 6(a)) by adding a constant amount of K₂RuCl₆ into varied volumes of electrolyte solution. It has been found that the less volume of electrolyte benefits the Ru nanoparticles deposition and leads to the better performance. The optimal conditions for the Ru NPs deposition have been defined as: 1 cm² electrode, 25 mL electrolyte, 400 µg K₂RuCl₆. This resulted in a decrease of the deposition time to only 3 hours and optimal HER performance, compared with those of the electrode produced using lower Ru precursor concentration, as demonstrated in linear sweep voltammogram (LSV) plots of Figure 6(b). ICP-OES elemental analysis revealed that a decrease in the volume of the electrolyte (while keeping the K₂RuCl₆ amount fixed) results in a higher loading of Ru onto the catalyst (Figure 6(c)), indicating an improved efficiency of the Ru nanoparticles deposition. It should be noted that the concentration of the Ru precursor does not affect the architecture of the microrods arrays (Figures 6(d)-(f)).

### Example 4 - HER activity and stability test

As shown in Figure 7, the Ru-TiO₂/Cu electrocatalyst according to the present invention, when compared with the commercial Pt/C catalyst (Platinum on graphitized carbon, 20 wt.% Pt loading, from Merck) deposited on a Cu mesh substrate (100 µL water dispersion of 5 mg/mL 20 wt.% Pt/C deposited onto 1 cm² Cu mesh substrate and dried naturally), displays much better catalytic activity towards HER in terms of onset potential (Figure 7(a)), Tafel slope (Figure 7(b), 23 mV/dec vs. 68 mV/dec) and stability (Figure 7(c)).

The good performance of the catalyst according to the present invention is believed to be due to several factors such as the facts that:
i) the TiO₂ helps in the water dissociation by binding OH species and, at the same time, releasing H species;
ii) the Ru nanoparticles help in the hydrogen evolution by combining H species;
iii) the Cu substrate serves as fast charge transfer medium.

The low Tafel slope characterizing the Ru-TiO₂/Cu electrocatalyst of the present invention demonstrates a fast HER kinetics which can be ascribed to the 3D architecture of the porous microrods composing it, which provides an ample surface area facilitating the diffusion of the electrolyte ions and the release of gaseous H₂. Moreover, the Ru-TiO₂/Cu electrocatalyst according to the present invention can deliver an industrial-level current density of -200 mA/cm² at a low overpotential of 65 mV and continuously works for more than 200 hours (no increase in the overpotential as shown in Figure 7(c)).

On the contrary, the commercial Pt/C, even though deposited on a Cu mesh substrate as that of the electrocatalyst of the present invention, requires a much higher overpotential (larger than 250 mV) to achieve similar currents and exhibits a severe performance decay within only 12 hours (~ 75 mV increase in overpotential).

The excellent stability of the electrocatalyst according to the present invention can be ascribed to the intimate contact between the Ru nanoparticles and the TiO₂/Cu microrods and between the TiO₂/Cu microrods and the Cu substrate, which prevents the agglomeration of Ru nanoparticles and the detachments of the microrods from the substrate during the HER. This was confirmed by the SEM images of the Ru-TiO₂/Cu microrods measured after the stability test (200 hours at -200 mA/cm²). As shown in Figure 8, the microrods array of the present invention is well anchored to the Cu mesh substrate and does not degrade after such prolonged utilization, demonstrating excellent durability.

Figure 7(d) shows a comparison of the electrocatalyst according to the present invention with the commercial Pt/C deposited on a Cu mesh substrate and with the previously reported Cu-Ru/Ti as described in J. Mater. Chem. A, 2020, 8, 10787 with respect to the mass activity (current per unit mass) and price activity (current per unit price).

The results clearly show the superior performances of the electrocatalyst according to the present invention.

### Example 5 - optimization of the Ti amount in the electrocatalyst of the invention

In the previous work of the Applicant, ACS Appl. Mater. Interfaces 2018, 10, 29583-29592, it has been proposed that the role of TiOₓ consists in facilitating the water dissociation, therefore improving the overall catalytic activity for HER in basic conditions. Nevertheless, TiOₓ is an electrical insulator and its relative amount in the final electrode must be finely tuned in order to increase the overall HER activity while retaining a good electrical conductivity. In this direction, different electrocatalysts have been realized with different amounts of Ti deposited onto the surface of the Cu(OH)₂ microrods.

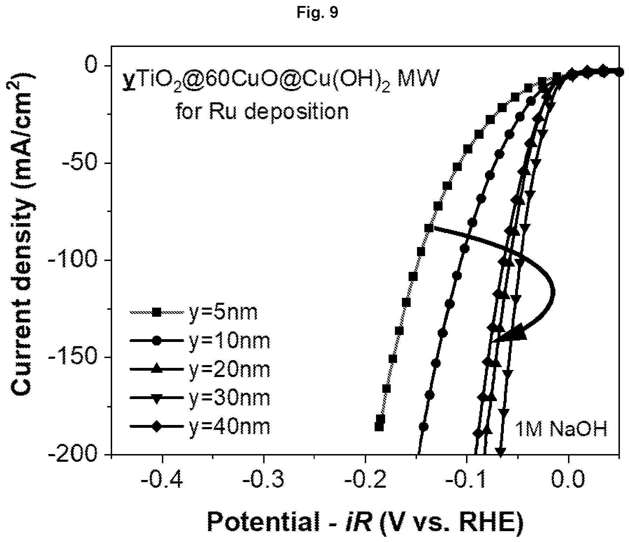

Figure 9 shows the LSV plots of TiO₂@CuO@Cu(OH)₂ electrocatalyst by varying the quantity of Ti sputtered and Table 1 shows the overpotential measured for each sample at current density of -200 mA/cm².

**Table 1**

| Deposited Ti thickness as set (nm) | Real amount (µg/cm² measured by ICP) | Overpotential at -200 mA/cm² (mV) |
|---|---|---|
| 10 | 10 | 147 |
| 20 | 24 | 83 |
| 30 | 31 | 65 |
| 40 | 35 | 92 |

The lower overpotential values are connected with better performances of the electrocatalyst according to the present invention. Therefore, the optimal amount of Ti (which corresponds to the amount of TiO₂ as the Ti is oxidized after exposure to air) is above 10 µg/cm² and lies in the preferred range 24-35 µg/cm².

## Claims

1. An electrocatalyst comprising a Cu substrate coated with a 3D TiO₂/Cu microrods array decorated with nanoparticles of a noble metal, wherein said Cu substrate is a Cu mesh, a Cu foil, or a plurality of Cu meshes or Cu foils forming a stack, and wherein said 3D TiO₂/Cu microrods array comprises TiO₂/Cu microrods vertically oriented with respect to said Cu substrate.

2. Electrocatalyst according to claim 1, wherein said 3D TiO₂/Cu microrods have a mean length measured by SEM technique comprised between 10 µm and 20 µm, wherein the mean length is the arithmetic mean of all the length values measured by SEM technique.

3. Electrocatalyst according to claim 1 or 2, wherein the TiO₂ is present in an amount between 10 and 40 µg/cm², more preferably between 20 and 35 µg/cm², wherein the amount is referred to the amount of TiO₂ per cm² of the projected area of the Cu substrate.

4. Electrocatalyst according to any one of the preceding claims, wherein the nanoparticles of a noble metal are present in an amount between 30 and 60 µg/cm², preferably between 40 and 55 µg/cm², wherein the amount is referred to the amount of TiO₂ per cm² of the projected area of the Cu substrate.

5. Electrocatalyst according to any one of the preceding claims, wherein the nanoparticles of a noble metal have a mean diameter measured by HRTEM technique of between 0.5 and 4 nm, preferably between 1 and 3 nm; and wherein the mean diameter is the arithmetic mean of all the diameter values measured by HRTEM technique.

6. Electrocatalyst according to any one of the preceding claims, wherein said noble metal is selected from the group consisting of: platinum (Pt), palladium (Pd), ruthenium (Ru) and gold (Au); preferably said noble metal is ruthenium (Ru).

7. An *in situ* process for the preparation of the electrocatalyst according to any one of claims 1-6 and simultaneous production of hydrogen comprising the steps of:
(a) providing a Cu substrate onto which vertically oriented Cu(OH)₂ microrods are grown;
(b) coating the Cu(OH)₂ microrods surface by means of a sputtering technique with a Cu layer, and, subsequently, with a Ti layer;
(c) providing an electrochemical cell having a 3-electrode configuration comprising a starting working electrode which comprises the Cu substrate coated with the vertically oriented Cu(OH)₂ microrods as obtained after step (b), the cell further comprising a counter electrode and a reference electrode;
(d) adding an aqueous basic electrolyte solution to the cell of step (c) and applying a negative current density to the cell, to obtain TiO₂/Cu microrods;
(e) adding a solution comprising a precursor of a noble metal directly into the aqueous basic electrolyte solution of step (d) and applying a negative potential with respect to the reference electrode to the cell.

8. Process according to claim 7, wherein the aqueous basic electrolyte solution of step (d) is in a concentration of between 0.1 and 1 M, the basic electrolyte solution being preferably selected from the group consisting of NaOH, KOH and LiOH aqueous solutions.

9. Process according to claim 7 or 8, wherein the precursor of a noble metal is in a concentration of between 0.2 and 10 µg/ml, preferably between 0.4 and 8 µg/ml.

10. Process according to any one of claims 7 to 9, wherein the Cu(OH)₂ microrods of step (a) are deposited onto the Cu substrate by a deposition process comprising the steps of:
(a.I) providing an aqueous basic solution, preferably an aqueous basic solution having a pH > 14, more preferably an aqueous basic solution comprising ammonium persulfate and sodium hydroxide;
(a.II) immersing a pre-cleaned Cu substrate into said solution at room temperature, said Cu substrate being used as Cu precursor for the heterogeneous nucleation reaction of vertically oriented Cu(OH)₂ microrods on the substrate.

11. Process according to any one of claims 7 to 10, wherein, in the cell of step (c), the reference electrode is a double junction Ag/AgCl reference electrode, the negative current density applied in step (d) is comprised preferably between -1 and -10 mA/cm², and the negative potential applied with respect to said reference electrode to the cell in step (e), is a negative potential of between -1.1 and -1.3 V.

12. An electrochemical cell having a 3-electrode configuration comprising the electrocatalyst according to any one of claims 1 to 6 as the working electrode, a counter electrode, a reference electrode and an aqueous basic electrolyte solution.

13. A process for producing hydrogen comprising:
- providing an electrochemical cell according to claim 12; and
- applying a negative potential with respect to the reference electrode to the cell.

14. Use of the electrocatalyst according to any one of claims 1 to 6 for hydrogen production *via* hydrogen evolution reaction under basic condition.

15. Use of the electrochemical cell according to claim 12, for hydrogen production *via* hydrogen evolution reaction under basic condition.

## Patentansprüche

1. Elektrokatalysator, umfassend ein Cu-Substrat, das mit einem Array von 3D TᵢO₂/Cu-Mikrostäbchen beschichtet ist, die mit Nanopartikeln eines Edelmetalls dekoriert sind, wobei das Cu-Substrat ein Cu-Netz, eine Cu-Folie oder eine Vielzahl von Cu-Netzen oder Cu-Folien ist, die einen Stapel bilden, und wobei das 3D TiO_{2/}Cu-Mikrostäbchen-Array TᵢO₂/Cu-Mikrostäbchen umfasst, die vertikal in Bezug auf das Cu-Substrat orientiert sind.

2. Elektrokatalysator nach Anspruch 1, wobei die 3D TᵢO₂/Cu-Mikrostäbchen eine mittels REM-Technik gemessene mittlere Länge zwischen 10 µm und 20 µm aufweisen, wobei die mittlere Länge der arithmetische Mittelwert aller mittels REM-Technik gemessenen Längenwerte ist.

3. Elektrokatalysator nach Anspruch 1 oder 2, wobei TiO₂ in einer Menge zwischen 10 und 40 µg/cm², bevorzugter zwischen 20 und 35 µg/cm² vorhanden ist, wobei die Menge auf die Menge an TᵢO₂ pro cm² der projizierten Fläche des Cu-Substrats bezogen ist.

4. Elektrokatalysator nach einem der vorhergehenden Ansprüche, wobei die Nanopartikel eines Edelmetalls in einer Menge zwischen 30 und 60 µg/cm², vorzugsweise zwischen 40 und 55 µg/cm² vorhanden sind, wobei die Menge auf die Menge an TᵢO₂ pro cm² der projizierten Fläche des Cu-Substrats bezogen ist.

5. Elektrokatalysator nach einem der vorhergehenden Ansprüche, wobei die Nanopartikel eines Edelmetalls einen mittels HRTEM-Technik gemessenen mittleren Durchmesser zwischen 0,5 und 4 nm, vorzugsweise zwischen 1 und 3 nm, aufweisen; und wobei der mittlere Durchmesser der arithmetische Mittelwert aller mittels HRTEM-Technik gemessenen Durchmesserwerte ist.

6. Elektrokatalysator nach einem der vorhergehenden Ansprüche, wobei das Edelmetall ausgewählt ist aus der Gruppe bestehend aus: Platin (Pt), Palladium (Pd), Ruthenium (Ru) und Gold (Au); vorzugsweise ist das Edelmetall Ruthenium (Ru).

7. In-situ-Verfahren zur Einrichtung des Elektrokatalysators nach einem der Ansprüche 1-6 und gleichzeitiger Erzeugung von Wasserstoff, umfassend die folgenden Schritte:
(a) Bereitstellen eines Cu-Substrats, auf dem vertikal orientierte Cu(OH)₂-Mikrostäbchen aufgewachsen sind;
(b) Beschichten der Oberfläche der Cu(OH)₂-Mikrostäbchen mittels einer Sputtertechnik mit einer Cu-Schicht und anschließend mit einer Ti-Schicht;
(c) Bereitstellen einer elektrochemischen Zelle mit einer 3-Elektroden-Auslegung, die eine Start-Arbeitselektrode umfasst, die das Cu-Substrat umfasst, das mit den vertikal orientierten Cu(OH)₂-Mikrostäbchen beschichtet ist, wie sie nach Schritt (b) erhalten wurden, wobei die Zelle ferner eine Gegenelektrode und eine Referenzelektrode umfasst;
(d) Zugeben einer wässrigen basischen Elektrolytlösung zu der Zelle von Schritt (c) und Anlegen einer negativen Stromdichte an die Zelle, um TᵢO₂/Cu-Mikrostäbchen zu erhalten;
(e) Zugeben einer Lösung, die einen Vorläufer eines Edelmetalls umfasst, direkt in die wässrige basische Elektrolytlösung von Schritt (d) und Anlegen eines negativen Potentials in Bezug auf die Referenzelektrode an die Zelle.

8. Verfahren nach Anspruch 7, wobei die wässrige basische Elektrolytlösung von Schritt (d) in einer Konzentration zwischen 0,1 und 1 M vorliegt, wobei die basische Elektrolytlösung vorzugsweise aus der Gruppe bestehend aus wässrigen NaOH-, KOH- und LiOH-Lösungen ausgewählt ist.

9. Verfahren nach Anspruch 7 oder 8, wobei der Vorläufer eines Edelmetalls in einer Konzentration zwischen 0,2 und 10 µg/ml, vorzugsweise zwischen 0,4 und 8 µg/ml vorliegt.

10. Verfahren nach einem der Ansprüche 7 bis 9, wobei die Cu(OH)₂-Mikrostäbchen von Schritt (a) durch ein Abscheidungsverfahren auf dem Cu-Substrat abgeschieden werden, das die folgenden Schritte umfasst:
(a.I) Bereitstellen einer wässrigen basischen Lösung, vorzugsweise einer wässrigen basischen Lösung mit einem pH-Wert > 14, bevorzugter einer wässrigen basischen Lösung, die Ammoniumpersulfat und Natriumhydroxid umfasst;
(a.II) Eintauchen eines vorgereinigten Cu-Substrats in die Lösung bei Raumtemperatur, wobei das Cu-Substrat als Cu-Vorläufer für die heterogene Keimbildungsreaktion von vertikal orientierten Cu(OH)₂-Mikrostäbchen auf dem Substrat verwendet wird.

11. Verfahren nach einem der Ansprüche 7 bis 10, wobei in der Zelle von Schritt (c) die Referenzelektrode eine Ag/AgCl-Referenzelektrode mit doppeltem Übergang ist, die in Schritt (d) angelegte negative Stromdichte vorzugsweise zwischen -1 und -10 mA/cm² liegt und das in Bezug auf die Referenzelektrode an die Zelle in Schritt (e) angelegte negative Potential ein negatives Potential zwischen -1,1 und -1,3 V ist.

12. Elektrochemische Zelle mit einer 3-Elektroden-Auslegung, umfassend den Elektrokatalysator nach einem der Ansprüche 1 bis 6 als Arbeitselektrode, eine Gegenelektrode, eine Referenzelektrode und eine wässrige basische Elektrolytlösung.

13. Verfahren zur Erzeugung von Wasserstoff, umfassend:
- Bereitstellen einer elektrochemischen Zelle nach Anspruch 12; und
- Anlegen eines negativen Potentials in Bezug auf die Referenzelektrode an die Zelle.

14. Verwendung des Elektrokatalysators nach einem der Ansprüche 1 bis 6 zur Wasserstofferzeugung über Wasserstoffentwicklungsreaktion unter basischen Bedingungen.

15. Verwendung der elektrochemischen Zelle nach Anspruch 12 zur Wasserstofferzeugung über Wasserstoffentwicklungsreaktion unter basischen Bedingungen.

## Revendications

1. Électrocatalyseur, comprenant un substrat de Cu revêtu d'un réseau de microtiges de TiO₂/Cu 3D parées de nanoparticules d'un métal noble, dans lequel ledit substrat de Cu est un treillis de Cu, une feuille de Cu ou une pluralité de treillis de Cu ou de feuilles de Cu formant une pile, et dans lequel ledit réseau de microtiges de TiO₂/Cu 3D comprend des microtiges de TiO₂/Cu orientées verticalement par rapport audit substrat de Cu.

2. Électrocatalyseur selon la revendication 1, dans lequel lesdites microtiges de TiO₂/Cu 3D ont une longueur moyenne mesurée par la technique SEM comprise entre 10 µm et 20 µm, dans lequel la longueur moyenne est la moyenne arithmétique de toutes les valeurs de longueur mesurées par la technique SEM.

3. Électrocatalyseur selon la revendication 1 ou 2, dans lequel le TiO₂ est présent dans une quantité comprise entre 10 et 40 µg/cm², de préférence entre 20 et 35 µg/cm², ladite quantité étant rapportée à la quantité de TiO₂ par cm² de la surface projetée du substrat de Cu.

4. Électrocatalyseur selon l'une quelconque des revendications précédentes, dans lequel les nanoparticules d'un métal noble sont présentes dans une quantité comprise entre 30 et 60 µg/cm², de préférence entre 40 et 55 µg/cm², ladite quantité étant rapportée à la quantité de TiO₂ par cm² de la surface projetée du substrat de Cu.

5. Électrocatalyseur selon l'une quelconque des revendications précédentes, dans lequel les nanoparticules d'un métal noble ont un diamètre moyen mesuré par la technique HRTEM compris entre 0,5 et 4 nm, de préférence entre 1 et 3 nm; et dans lequel le diamètre moyen est la moyenne arithmétique de toutes les valeurs de diamètre mesurées par la technique HRTEM.

6. Électrocatalyseur selon l'une quelconque des revendications précédentes, dans lequel ledit métal noble est choisi dans le groupe constitué par : le platine (Pt), le palladium (Pd), le ruthénium (Ru) et l'or (Au) ; de préférence, ledit métal noble est le ruthénium (Ru).

7. Procédé *in situ* pour la préparation de l'électrocatalyseur selon l'une quelconque des revendications 1-6 et la production simultanée d'hydrogène, comprenant les étapes de :
(a) fournir un substrat de Cu sur lequel sont développées des microtiges de Cu(OH)₂ orientés verticalement ;
(b) revêtir la surface des microtiges de Cu(OH)₂ au moyen d'une technique de pulvérisation cathodique avec une couche de Cu et, ensuite, avec une couche de Ti ;
(c) fournir une cellule électrochimique ayant une configuration à 3 électrodes comprenant une électrode à étudier d'amorçage qui comprend le substrat de Cu revêtu des microtiges de Cu(OH)₂ orientées verticalement telles qu'obtenues après l'étape (b), la cellule comprenant en outre une contre-électrode et une électrode de référence ;
(d) ajouter une solution aqueuse électrolytique basique à la cellule de l'étape (c) et appliquer une densité de courant négative à la cellule, afin d'obtenir des microtiges de TiO₂/Cu ;
(e) ajouter une solution comprenant un précurseur d'un métal noble directement dans la solution aqueuse électrolytique basique de l'étape (d) et appliquer un potentiel négatif par rapport à l'électrode de référence à la cellule.

8. Procédé selon la revendication 7, dans lequel la solution aqueuse électrolytique basique de l'étape (d) est à une concentration comprise entre 0,1 et 1 M, la solution électrolytique basique étant de préférence choisie dans le groupe constitué par les solutions aqueuses de NaOH, KOH et LiOH.

9. Procédé selon la revendication 7 ou 8, dans lequel le précurseur d'un métal noble est à une concentration comprise entre 0,2 et 10 µg/ml, de préférence entre 0,4 et 8 µg/ml.

10. Procédé selon l'une quelconque des revendications 7 à 9, dans lequel les microtiges de Cu(OH)₂ de l'étape (a) sont déposées sur le substrat de Cu par un procédé de dépôt comprenant les étapes de :
(a.I) fournir une solution aqueuse basique, de préférence une solution aqueuse basique ayant un pH > 14, plus préférablement une solution aqueuse basique comprenant du persulfate d'ammonium et de l'hydroxyde de sodium ;
(a.II) immerger un substrat de Cu pré-nettoyé dans ladite solution à température ambiante, ledit substrat de Cu étant utilisé comme précurseur de Cu pour la réaction de nucléation hétérogène de microtiges de Cu(OH)₂ orientées verticalement sur le substrat.

11. Procédé selon l'une quelconque des revendications 7 à 10, dans lequel, dans la cellule de l'étape (c), l'électrode de référence est une électrode de référence à double jonction Ag/AgCl, la densité de courant négative appliquée à l'étape (d) est comprise de préférence entre - 1 et - 10 mA/cm², et le potentiel négatif appliqué par rapport à ladite électrode de référence à la cellule à l'étape (e) est un potentiel négatif compris entre - 1,1 et - 1,3 V.

12. Cellule électrochimique présentant une configuration à 3 électrodes comprenant l'électrocatalyseur selon l'une quelconque des revendications 1 à 6 en tant qu'électrode à étudier, une contre-électrode, une électrode de référence et une solution aqueuse électrolytique basique.

13. Procédé de production d'hydrogène, comprenant :
- fournir une cellule électrochimique selon la revendication 12 ; et
- appliquer un potentiel négatif par rapport à l'électrode de référence à la cellule.

14. Utilisation de l'électrocatalyseur selon l'une quelconque des revendications 1 à 6, pour la production d'hydrogène via une réaction de dégagement d'hydrogène dans des conditions basiques.

15. Utilisation de la cellule électrochimique selon la revendication 12, pour la production d'hydrogène via une réaction de dégagement d'hydrogène dans des conditions basiques.
